# EUROPÄISCHE PATENTSCHRIFT

(11) **EP 2 076 100 B1**
(45) Veröffentlichungstag und Bekanntmachung des Hinweises auf die Patenterteilung: **10.11.2010**
(21) Anmeldenummer: 09003831.6
(22) Anmeldetag: 24.01.2006
(51) Int. Cl.: H05K 1/02, H05K 3/10, H05K 3/22

(54) **Drahtbeschriebene Leiterplatte oder Platine mit geätzten Leiterbahnen und Anschlussstellen und Verfahren zur Herstelleung einer drahtbeschriebenen Leiterplatte oder Platine mit geätzten Anschlussstellen.**
Wire-written circuit board or board with etched circuit routes and contact pads and method for manufacturing a wire-written circuit board or board with etched contact pads.
Carte de circuits imprimés ou platine munie de fils conducteurs et de pistes conductrices et zones de contact gravées et procédé de fabrication d'une carte de circuits imprimés ou platine munie de fils conducteurs et de zones de contact gravées

(30) Priorität: 24.01.2005 DE 202005001161 U
(43) Veröffentlichungstag der Anmeldung: 01.07.2009
(62) Teilanmeldung aus: 06706388.3
(73) Patentinhaber: JUMATECH GmbH, 90542 Eckental (DE)
(72) Erfinder: Wölfel, Markus, 91207 Lauf (DE)
(74) Vertreter: Grünecker, Kinkeldey, Stockmair & Schwanhäusser Anwaltssozietät

(56) Entgegenhaltungen:
- WO-A-93/26141
- DE-A1- 10 255 277
- DE-A1- 19 753 125
- DE-C1- 19 618 917
- US-A- 5 895 277
- US-A- 5 902 138
- US-A- 6 008 987
- US-B2- 6 800 807

## Beschreibung

### Stand der Technik

Die Erfindung geht aus von einer drahtbeschriebenen Leiterplatte oder Platine mit sich auf und/oder in der Leiterplatte oder Platine zwischen Anschlussstellen erstreckenden Leitungsdrähten.

Üblicherweise werden Leiterbahnen auf Platinen oder Leiterplatten durch das Ätzverfahren hergestellt, d.h. von einer auf einer Trägerplatte aufgebrachten Kupferfolie werden zwischen den gewünschten Leiterbahnen liegende Bereiche abgeätzt. Bei drahtbeschriebenen Leiterplatten oder Platinen werden hingegen Leitungsdrähte aus elektrisch leitfähigem Material zwischen auf der Platine angeordneten Anschlussstellen der auf der Platine aufzubringenden elektronischen Bauelemente verlegt und beispielsweise zusammen mit der Platine in Verbundbauweise in einen Block aus Isoliermasse eingegossen. Ein Verfahren zur Herstellung einer solchen drahtbeschriebnen Leiterplatte oder Platine ist beispielsweise aus der DE 196 18 917 C1 bekannt. Zu unterscheiden sind folglich drahtbeschriebene Platinen, auf oder in welchen Leitungsdrähte zwischen Anschlussstellert elektronischer Bauelemente verlegt sind von Leitungsverbindungen, bei welchen durch die Leitungsdrähte lediglich Ströme oder Signale zwischen getrennten Platinen oder Leiterplatten übertragen werden.

Für komplexe Schaltungen auf Platinen sind oft eine Vielzahl von sich kreuzenden Leitungsdrähten auf der Platine erforderlich, welche dann einen relativ großen Bauraum in Anspruch nehmen. Weiterhin ergeben sich besonders dann, wenn die Platine oder Leiterplatte im Bereich der Leistungselektronik eingesetzt wird, thermische Problemen in Form von Überhitzung.

Der vorliegenden Erfindung liegt demzufolge die Aufgabe zugrunde, eine drahtbeschriebene Leiterplatte oder Platine der eingangs erwähnten Art derart weiter zu entwickeln, dass die oben beschriebenen Nachteile weitgehend vermieden werden.

Erfindungsgemäß wird diese Aufgabe durch die Merkmale des Schutzanspruchs 1 gelöst.

### Vorteile der Erfindung

Die Erfindung basiert auf dem Gedanken, den Querschnitt zumindest einiger der auf einer Platine oder Leiterplatte verlegten Leitungsdrähte rechteckig oder quadratisch zu gestalten. Die damit verbundenen Vorteile sind gegenüber Leitungsdrähten mit kreisförmigem Querschnitt sind vor allem darin zu sehen, dass die Zwischenräume zwischen den einzelnen Leitungsdrähten kleiner ausfallen können und deshalb eine höhere Packungsdichte erzielbar ist. Weiterhin lassen sich auf gleichem Bauraum größere Leitungsquerschnitte realisieren, was vor allem beim Einsatz von Leitungsdrähten bei Leistungselektroniken von Vorteil ist, bei welchen es aus Temperaturgründen auf große leitende Querschnitte ankommt Darüber hinaus wird bei größeren Leitungsquerschnitten auch ein geringerer Leitungswiderstand erzielt, so dass auch sehr hohe Ströme mit wenig Verlust übertragen werden können. Infolgedessen kann auf einer einzigen Leiterplatte neben der Schaltungselektronik auch die Leistungselektronik angeordnet werden.

Weiterhin sind Kreuzungen von erfindungsgemäß gestalteten stromführenden Leitungsdrähten zu realisieren, da die Kontaktfläche der Leitungsdrähte größer ist und sich deshalb isolierende Zwischenlagen leichter anbringen lassen. Zudem ergibt sich bei gegebenen Leitungsquerschnitten an Kreuzungen eine geringere Bauhöhe als bei Leitungsdrähten mit Kreisquerschnitt.

Durch die in den Unteransprüchen aufgeführten Maßnahmen sind vorteilhafte Weiterbildungen und Verbesserungen der im Anspruch 1 angegebenen Erfindung möglich.

Besonders bevorzugt weist von zumindest einigen der Leitungsdrähte mit rechteckigem Querschnitt die Seite mit der größeren Ausdehnung zur Leiterplatte hin. Dann ergibt sich zum einen eine flache Bauhöhe, zum anderen können die Leitungsdrähte wegen der geringeren Neigung zum Kippen oder Verdrehen einfacher an der Platine fixiert werden, beispielsweise durch Umgießen mit einem elektrischen Isoliermaterial.

Gemäß einer Weiterbildung weisen zumindest einige der Leitungsdrähte einen hohlen Querschnitt auf, in welchem ein Medium zirkuliert. Bei dem Medium kann es sich um ein Gas oder eine Flüssigkeit handeln. Das Medium kann z.B. ein Kühlmittel zum Kühlen der Leiterplatte sein. Diese Ausgestaltung ist vor allem beim Einsatz von hochstromdurchflossenen Leitungsdrähten, wie sie in einer Leistungselektronik eingesetzt werden, von Vorteil, da dadurch die Temperatur herabgesetzt wird. Für bestimmte Einsätze der Leiterplatte kann es auch vorteilhaft sein, wenn das Medium ein Mittel zum Heizen, z.B. eine erwärmte Flüssigkeit oder ein Gas ist. Insbesondere bei kalter Umgebung oder zum schnellen Erreichen der Betriebstemperatur der Leiterplatte kann dies vorteilhaft sein. Auch können durch Heizen/Kühlen große Temperaturschwankungen der Umgebung ausgeglichen werden, wenn die Leiterplatte sozusagen klimatisiert wird.

### Zeichnungen

Nachstehend sind Ausführungsbeispiele der Erfindung in der Zeichnung dargestellt und in der nachfolgenden Beschreibung näher erläutert. In der Zeichnung zeigt:
- Fig. 1: eine perspektivische Ansicht einer Leiterplatte, bei welcher mehrere elekt- risch leitfähige Leitungsdrähte Anschlussstellen für elektronische Bauele- mente miteinander verbinden;
- Fig. 2: eine Querschnittsdarstellung durch die Leiterplatte von Fig. 1 mit einem Leitungsdraht mit rechteckförmigem Querschnitt gemäß einer bevorzugten Ausführungsform der Erfindung;
- Fig. 3: eine Querschnittsdarstellung durch die Leiterplatte von Fig. 1 mit einem Leitungsdraht mit rechteckförmigem, hohlem Querschnitt gemäß einer wei- teren Ausführungsform der Erfindung;
- Fig. 4: eine Querschnittsansicht der Leiterplatte von Fig. 1 mit einem im Quer- schnitt gesehenen rechteckigen und einem im Querschnitt gesehenen hohlen Leitungsdraht, wobei die Leiterplatine mehrschichtig aufgebaut ist.
- Fig. 5: eine perspektivische Ansicht der Leiterplatte aus Fig. 4.

### Beschreibung der Ausführungsbeispiele

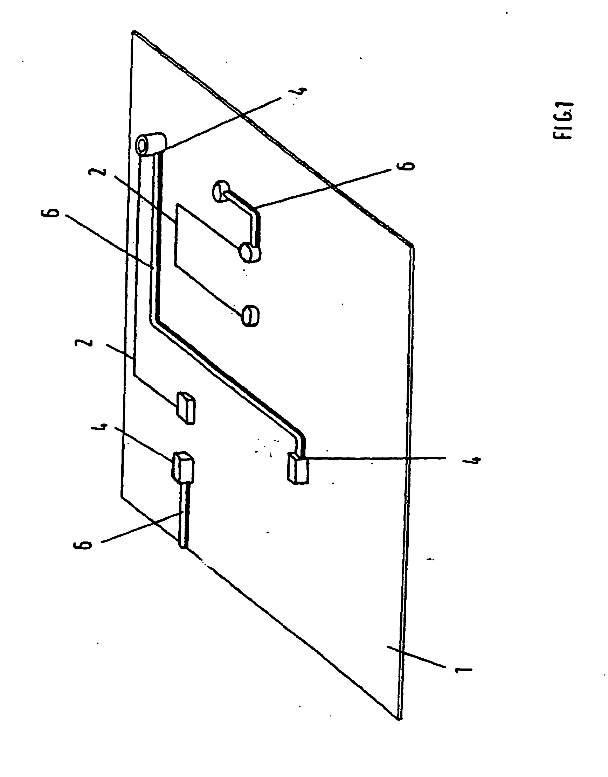

Die in Fig. 1 insgesamt mit 1 bezeichnete, elektrisch isolierende Leiterplatte ist bevorzugt eine geätzte Leiterplatte, d.h. auf ihrer Oberfläche befinden sich sehr flache Leiterbahnen 2 aus Kupfer, welche eine elektrische Schaltung ausbilden.

Zusätzlich ist auf der Leiterplatte 1 eine Leistungselektronik verwirklicht, mit nicht gezeigten elektronischen Leistungsbauelementen, deren beispielsweise geätzte Anschlussstellen 4 durch elektrisch leitfähige Leitungsdrähte 6 miteinander in Verbindung stehen. Die Leitungsdrähte 6 kontaktieren daher an definierten Anschlussstellen 4 von elektronischen Bauelementen der Schaltung die Leiterplatte 1. Diese Kontaktierung erfolgt beispielsweise durch Schweißung, Bonden, Löten, Leitkleben oder dergleichen. Die Leitungsdrähte 6 sind beispielsweise mit einer Isolierung versehen, um sie in mehreren Ebenen übereinander anordnen zu können. Eine solche Leiterplatte wird als drahtbeschriebene Leiterplatte 1 bezeichnet. Die Leiterplatte 1 kann weiterhin auf ihrer zu den Leitungsdrähten 6 weisenden Seite mit diesen durch eine elektrische Isolierstoffmasse in Verbundbauweise vergossen sein. Im vorliegenden Fall ist folglich auf der Leiterplatte 1 eine Kombination von geätzten Leiterbahnen 2 und Drahtverbindungen mit Leitungsdrähten 6 verwirklicht.

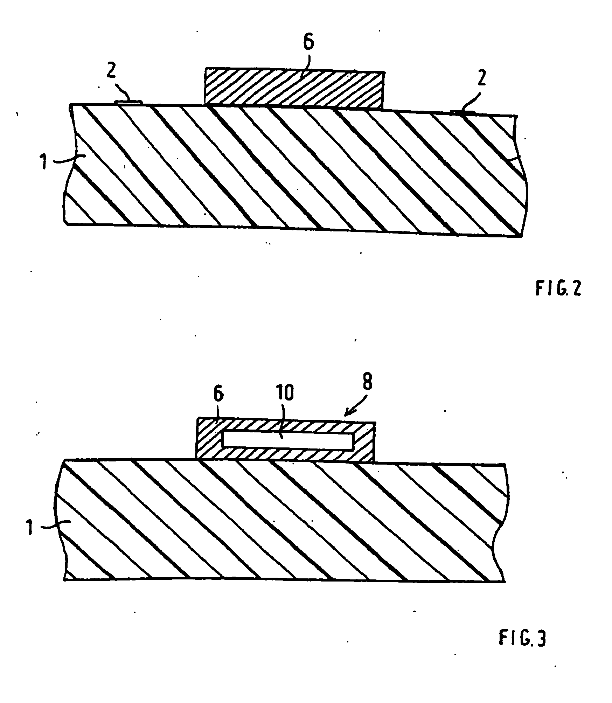

Erfindungsgemäß weisen zumindest einige der Leitungsdrähte 6 einen rechteckförmigen Querschnitt auf, wie aus Fig. 2 hervorgeht. Vorzugsweise ist ein solcher Leiterdraht 6 als Flachdraht aus Kupfer ausgebildet und hat die Abmessungen 0,8 x 0,3 mm. Von den Leitungsdrähten 6 weist beispielsweise die Seite mit der größeren Ausdehnung zur Leiterplatte 1 hin.

Gemäß einer weiteren, in Fig. 3 gezeigten Ausführungsform weisen zumindest einige der Leitungsdrähte 6 einen hohlen Querschnitt 8 auf, in welchem vorzugsweise eine Kühlflüssigkeit 10 oder auch nur Luft zirkuliert.

Gemäß einer Alternative kann die Ätzung der auf der Oberfläche der Leiterplatte befestigten Kupferfolie auch erst nach dem Verlegen bzw. Drahtschreiben der Leitungsdrähte erfolgen, um die Anschlussstellen aus der Kupferfolie herausarbeiten. Da diese jedoch gemäß des vorhandenen Schaltungs-Layouts bereits vorab bekannt ist, können die Verbindungen der Leitungsdrähte mit den eigentlich noch nicht vorhandenen Anschlussstellen bereits vorab gefertigt werden. Zusätzlich kann die mit den Leitungsdrähten versehene Oberfläche der Leiterplatte mit einer Decksicht versehen werden, beispielsweise dadurch, dass ein prepreg aus Isolierstoffmasse mit der Leiterplatte verpresst wird.

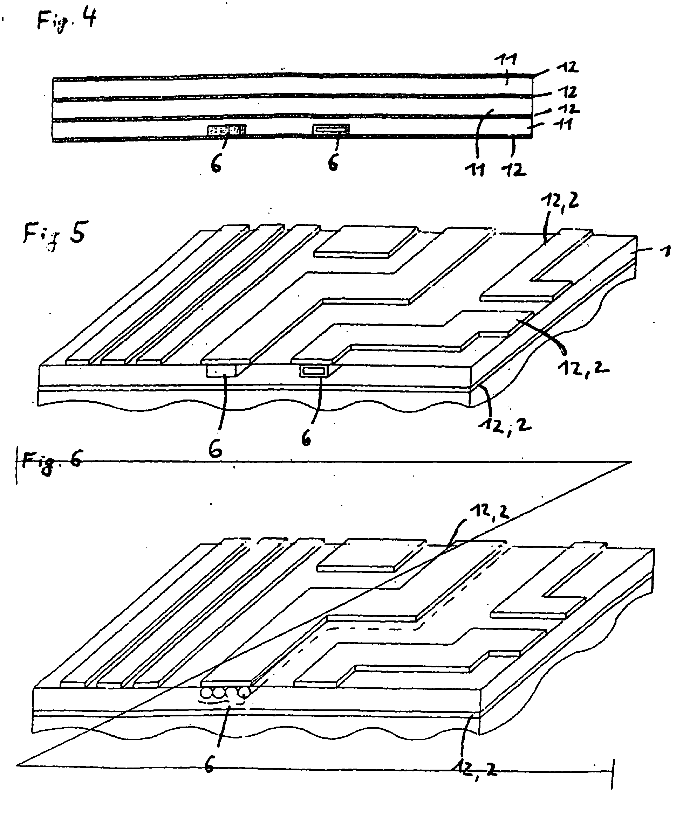

Die Figuren 4 und 5 zeigen eine weitere Ausführungsform, bei der die Leiterplatine mehrschichtig aufgebaut ist mit mehreren Schichten 12 aus leitfähigem Material, wie z. B. Kupfer. Die im Querschnitt rechteckigen oder hohlen Leitungsdrähte 6 befinden sich dabei innerhalb der Leiterplatte. Die Leitungsdrähte 6 sind z. B. in ein lsoliermittel 11, welches die Schichten 12 elektrisch voneinander trennt, eingegossen. Auf der Außenseite der Leiterplatte sind durch Ätzung erzeugte Leitungsbahnen 2 dargestellt. Diese Leitungsbahnen können z. B. an die im Querschnitt gesehenen rechteckigen oder hohlen Leitungsdrähte angrenzen bzw. damit verbunden sein. Bei dieser Ausführungsform sind die im Querschnitt rechteckigen oder hohlen Leitungsdrähte 6 von außen nicht sichtbar, sie verlaufen aber entlang zugeordneter Leitungsbahnen. Die Schichten 12 und das Isoliermaterial sind mit den Leitungsdrähten 6 und etwaigen anderen Komponenten zu einer Leiterplatte in bekannter Weise verpresst.

Die im Wesentlichen rechteckige Gestaltung der Leitungsdrähte ist nicht auf ein geometrisch exaktes Rechteck begrenzt. So kann der Leitungsdraht auch eine Grundform aufweisen, die von einem geometrischen Rechteck abweicht. Z. B. können die Kanten abgerundet oval sein. Entscheidend ist, dass die Höhe der Leitungsdrähte 6 ein Vielfaches der Höhe der Leitungsbahnen entspricht bzw. der Folie, auf welche die Leitungsdrähte 6 beim Herstellen der Leitungsplatte im Wege der Drahtschreibung aufgebracht wurden (Leitungsdrähte 6 folgen dem Verlauf der daran angrenzenden Leitungsbahnen 12), wobei die Bezeichnung hoch entsprechend den Darstellungen in der Zeichnung senkrecht zur flächigen Ausdehnung der Leiterplatte zu sehen ist. Sofern man einen im Wesentlichen rechteckigen Querschnitt wählt, kann dieser sehr flach gestaltet sein und eine vergleichsweise große Querschnittsfläche aufweisen, um dadurch auch vergleichsweise große Ströme transportieren zu können. Bei der Ausführungsform in Figur 5 ist die Schicht 12 durch Ätzen zu Leiterbahnen 2 ausgebildet.

## Patentansprüche

1. Drahtbeschriebene Leiterplatte (1) oder Platine mit geätzten Leiterbahnen (2) und mit sich in der Leiterplatte (1) oder Platine zwischen Anschlussstellen (4) von elektronischen Bauelementen erstreckenden Leitungsdrähten (6), wobei zumindest einige der Leitungsdrähte (6) einen rechteckförmigen Querschnitt aufweisen, und die Seite mit der größeren Ausdehnung zur Oberfläche der Leiterplatte (1) oder Platine weist, wobei die Anschlussstellen (4) geätzt sind.

2. Drahtbeschriebene Leiterplatte (1) oder Platine nach einem der vorangegangenen Ansprüche, **dadurch gekennzeichnet, dass** die Leitungsdrähte (6) die Anschlussstellen (4) kontaktieren.

3. Drahtbeschriebene Leiterplatte (1) oder Platine nach einem der vorangegangenen Ansprüche, **dadurch gekennzeichnet, dass** die Kontaktierung eine Schweißungskontaktierung ist.

4. Drahtbeschriebene Leiterplatte (1) oder Platine nach einem der vorangegangenen Ansprüche, **dadurch gekennzeichnet, dass** auf der Leiterplatte (1) oder Platine Schaltungselektronik und/oder Leistungselektronik angeordnet ist.

5. Drahtbeschriebene Leiterplatte (1) oder Platine nach einem der vorangegangenen Ansprüche, **dadurch gekennzeichnet, dass** die geätzten Anschlussstellen (4) von elektronischen Leistungsbauelementen über Leitungsdrähte (6) in Verbindung stehen.

6. Drahtbeschriebene Leiterplatte (1) oder Platine nach einem der vorangegangenen Ansprüche, **dadurch gekennzeichnet, dass** die Leitungsdrähte (6) sich kreuzen.

7. Drahtbeschriebene Leiterplatte (1) oder Platine nach einem der vorangegangenen Ansprüche, **dadurch gekennzeichnet, dass** die Leitungsdrähte (6) dem Verlauf der Leitungsbahnen (2, 12) folgen.

8. Verfahren zur Herstellung einer drahtbeschriebenen Leiterplatte (1) oder Platine mit sich in der Leiterplatte (1) oder Platine zwischen Anschlussstellen (4) erstreckenden Leitungsdrähten (6), wobei zumindest einige der Leitungsdrähte (6) einen rechteckförmigen Querschnitt aufweisen, und die Seite mit der größeren Ausdehnung zur Oberfläche der Leiterplatte (1) oder Platine weist, wobei die Anschlussstellen (4) durch Ätzung aus einer auf der Oberfläche der Leiterplatte (1) oder Platine befestigten Kupferfolie herausarbeitet werden.

9. Verfahren zur Herstellung einer drahtbeschriebenen Leiterplatte (1) oder Platine nach Anspruch 8, **dadurch gekennzeichnet, dass** die Ätzung der Kupferfolie nach dem Verlegen der Leitungsdrähte (6) erfolgt.

10. Verfahren zur Herstellung einer drahtbeschriebenen Leiterplatte (1) oder Platine nach Anspruch 8 oder 9, **dadurch gekennzeichnet, dass** die Verbindungen der Leitungsdrähte (6) mit den Anschlussstellen (4) vor Ätzung der Kupferfolie gefertigt werden.

11. Verfahren zur Herstellung einer drahtbeschriebenen Leiterplatte (1) oder Platine nach einem der Ansprüche 8 bis 10, **dadurch gekennzeichnet, dass** die Leitungsdrähte mit einem elektrischen Isoliermaterial umgossen werden.

## Claims

1. Wire-written printed circuit board (1) or circuit board having etched conductor tracks (2) and having conduction wires (6) extending in the printed circuit board (1) or circuit board between connection locations (4) of electronic components, wherein at least some of the conduction wires (6) have a rectangular cross section, and the side having the larger extent faces the surface of the printed circuit board (1) or circuit board, wherein the connection locations (4) are etched.

2. Wire-written printed circuit board (1) or circuit board according to the preceding claim, **characterized in that** the conduction wires (6) make contact with the connection locations (4).

3. Wire-written printed circuit board (1) or circuit board according to either of the preceding claims, **characterized in that** the contact-connection is a welding contact-connection.

4. Wire-written printed circuit board (1) or circuit board according to any of the preceding claims, **characterized in that** circuit electronics and/or power electronics are arranged on the printed circuit board (1) or circuit board.

5. Wire-written printed circuit board (1) or circuit board according to any of the preceding claims, **characterized in that** the etched connection locations (4) of electronic power components are connected by means of conduction wires (6).

6. Wire-written printed circuit board (1) or circuit board according to any of the preceding claims, **characterized in that** the conduction wires (6) cross one another.

7. Wire-written printed circuit board (1) or circuit board according to any of the preceding claims, or **characterized in that** the conduction wires (6) follow the course of the conduction tracks (2, 12).

8. Method for producing a wire-written printed circuit board (1) or circuit board having conduction wires (6) extending in the printed circuit board (1) or circuit board between connection locations (4), wherein at least some of the conduction wires (6) have a rectangular cross section, and the side having the larger extent faces the surface of the printed circuit board (1) or circuit board, wherein the connection locations (4) are worked from a copper foil fixed on the surface of the printed circuit board (1) or circuit board, by means of etching.

9. Method for producing a wire-written printed circuit board (1) or circuit board according to Claim 8, **characterized in that** the etching of the copper foil is effected after the conduction wires (6) have been laid.

10. Method for producing a wire-written printed circuit board (1) or circuit board according to Claim 8 or 9, **characterized in that** the connections of the conduction wires (6) to the connection locations (4) are produced prior to the etching of the copper foil.

11. Method for producing a wire-written printed circuit board (1) or circuit board according to any of Claims 8 to 10, **characterized in that** the conduction wires are encapsulated with an electrical insulation material by casting.

## Revendications

1. Carte de circuits imprimés (1) ou platine munie de fils conducteurs ayant des pistes conductrices (2) gravées et munies de fils conducteurs (6) qui s'étendent dans la carte de circuits imprimés (1) ou la platine entre des pôles de connexion (4) de composants électroniques, où au moins un des fils conducteurs (6) possède une découpe de forme rectangulaire, et la face qui possède la plus grande expansion pointe vers la surface de la carte de circuit imprimés (1) ou de la platine, où le pôles de connexion (4) sont gravés.

2. Carte de circuits imprimés (1) ou platine munie de fils conducteurs suivant l'une des revendications précédentes, **caractérisée en ce que** les fils conducteurs (6) sont en contact avec les pôles de connexion (4).

3. Carte de circuits imprimés (1) ou platine munie de fils conducteurs suivant l'une des revendications précédentes, **caractérisée en ce que** la façon d'être en contact est un contact par soudure.

4. Carte de circuits imprimés (1) ou platine munie de fils conducteurs suivant l'une des revendications précédentes, **caractérisée en ce que** de l'électronique de branchement et/ou de l'électronique de puissance est disposée sur la carte de circuit imprimés (1) ou sur la platine.

5. Carte de circuits imprimés (1) ou platine munie de fils conducteurs suivant l'une des revendications précédentes, **caractérisée en ce que** les pôles de connexion gravés (4) des composants électroniques de puissance sont en communication par l'intermédiaire de fils conducteurs (6).

6. Carte de circuits imprimés (1) ou platine munie de fils conducteurs suivant l'une des revendications précédentes, **caractérisée en ce que** les fils conducteurs (6) se croissent.

7. Carte de circuits imprimés (1) ou platine munie de fils conducteurs suivant l'une des revendications précédentes, **caractérisée en ce que** les fils conducteurs (6) suivent le parcours des pistes conductrices (2,12).

8. Procédé de fabrication d'une carte de circuits imprimés (1) ou platine munie de fils conducteurs ayant des fils conducteurs (6) qui s'étendent dans la carte de circuits imprimés (1) ou la platine entre des pôles de connexion (4), où au moins un des fils conducteurs (6) possède une découpe de forme rectangulaire, et la face qui possède la plus grande expansion pointe vers la surface de la carte de circuit imprimés (1) ou de la platine, où les pôles de connexion (4) sont façonnés par décapage à partir d'une feuille de cuivre attachée à la surface de la carte de circuits imprimés (1) ou de la platine.

9. Procédé de fabrication d'une carte de circuits imprimés (1) ou platine munie de fils conducteurs suivant la revendication 8, **caractérisé en ce que** le décapage de la feuille de cuivre est réalisé après la pose des fils conducteurs (6).

10. Procédé de fabrication d'une carte de circuits imprimés (1) ou platine munie de fils conducteurs suivant la revendication 8 ou 9, **caractérisé en ce que** les liaisons des fils conducteurs (6) avec les pôles de connexion (4) sont achevées avant le décapage de la feuille de cuivre.

11. Procédé de fabrication d'une carte de circuits imprimés (1) ou platine munie de fils conducteurs suivant l'une des revendications 8 à 10, **caractérisé en ce que** les fils conducteurs sont enrobés d'une matière isolant l'électricité.
